# EUROPÄISCHE PATENTSCHRIFT

(11) **EP 1 163 679 B1**
(45) Veröffentlichungstag und Bekanntmachung des Hinweises auf die Patenterteilung: **04.12.2002**
(21) Anmeldenummer: 00912402.5
(22) Anmeldetag: 02.03.2000
(51) Int. Cl.: G11C 29/00

(54) **BETRIEBSVERFAHREN FÜR EINEN INTEGRIERTEN SPEICHER MIT BESCHREIBBAREN SPEICHERZELLEN UND ENTSPRECHENDER INTEGRIERTER SPEICHER**
METHOD OF OPERATING AN INTEGRATED MEMORY WITH WRITABLE MEMORY CELLS AND CORRESPONDING INTEGRATED MEMORY
PROCEDE PERMETTANT DE FAIRE FONCTIONNER UNE MEMOIRE INTEGREE A CELLULES INSCRIPTIBLES ET MEMOIRE INTEGREE ASSOCIEE

(30) Priorität: 25.03.1999 DE 19913570
(43) Veröffentlichungstag der Anmeldung: 19.12.2001
(73) Patentinhaber: Infineon Technologies AG, 81669 München (DE)
(72) Erfinder: BÖHM, Thomas, D-85604 Zorneding (DE); BRAUN, Georg, D-80339 München (DE)
(74) Vertreter: Müller - Hoffmann & Partner
(86) Internationale Anmeldenummer: DE0000654
(87) Internationale Veröffentlichungsnummer: WO00058972

(56) Entgegenhaltungen:
- US-A- 5 742 548

## Beschreibung

Die Erfindung betrifft ein Betriebsverfahren für einen integrierten Speicher mit beschreibbaren Speicherzellen sowie einen entsprechenden integrierten Speicher.

Bekannte integrierte Speicher mit beschreibbaren Speicherzellen sind beispielsweise DRAMs (Dynamic Random Access Memories) und FRAMs bzw. FeRAMs (Ferroelectric RAM). Diese beiden Speicherarten weisen jeweils Speicherzellen mit wenigstens einem Speicherkondensator auf, der zum Speichern von Daten dient. Allgemein üblich sind bei DRAMs Speicherzellen vom Ein-Transistor/Ein-Kondensator-Typ. Speicherzellen von FRAMs können ebenfalls vom Ein-Transistor/Ein-Kondensator-Typ sein. Sie unterscheiden sich dann von den Speicherzellen eines DRAMs darin, daß ihr Speicherkondensator ein ferroelektrisches Dielektrikum aufweist. Durch unterschiedliche Polarisation des ferroelektrischen Dielektrikums können verschiedene logische Zustände eines zu speichernden Datums unterschieden werden, da sich die Kapazität des Kondensators mit seiner Polarisation ändert.

In der US 5,592,410 A ist ein FRAM mit Speicherzellen vom Zwei-Transistor/Zwei-Kondensator-Typ beschrieben. Auch bei diesem weisen die beiden Speicherkondensatoren jeder Speicherzelle ein ferroelektrisches Dielektrikum auf.

Aus der US 5,742,548 A ist ein EEPROM bekannt, bei dem zur Überprüfung des korrekten Ablaufs eines Schreiboperation eine Testzelle vor und nach der Schreiboperation auf unterschiedliche Werte gesetzt und der Inhalt der Festzelle ausgewertet wird.

Der Erfindung liegt die Aufgabe zugrunde, ein Betriebsverfahren für einen integrierten Speicher mit beschreibbaren Speicherzellen anzugeben, mit dem festgestellt wird, ob im vorhergehenden Betrieb des Speichers eine Funktionsstörung aufgetreten ist. Eine weitere Aufgabe ist die Angabe eines entsprechenden integrierten Speichers, der die Durchführung dieses Betriebsverfahrens ermöglicht.

Diese Aufgaben werden mit einem Betriebsverfahren gemäß Patentanspruch 1 bzw. mit einem integrierten Speicher gemäß Patentanspruch 4 gelöst. Vorteilhafte Aus- und Weiterbildungen der Erfindung sind Gegenstand der abhängigen Patentansprüche.

Erfindungsgemäß weist der ihtegrierte Speicher eine Sicherheitsspeicherzelle auf, die bei einem Zugriff auf eine der normalen Speicherzellen ebenfalls ausgelesen wird. Ergibt das Auslesen einer in der Sicherheitsspeicherzelle gespeicherten Sicherheitsinformation, daß deren logischer Zustand nicht demjenigen logischen Zustand entspricht, mit dem die Sicherheitsinformation zuvor in die Sicherheitsspeicherzelle eingeschrieben werden sollte, wird ein entsprechendes Fehlersignal generiert. Das Fehlersignal zeigt dann an, daß das Speichern der Sicherheitsinformation mit bekanntem zweiten logischen Zustand nicht in Korrekter Weise erfolgte. Da diese Funktionsstörung des Speichers auch Auswirkungen auf das Speichern des gerade auszulesenden Datums aus der Speicherzelle gehabt haben könnte, eignet sich das Fehlersignal als entsprechende Warnung für den Betreiber des integrierten Speichers.

Wird beim Auslesen der Sicherheitsspeicherzelle keine Funktionsstörung des Speichers detektiert, hat die Sicherheitsinformation also den zweiten logischen Zustand, wird der Sicherheitsspeicherzelle eine neue zu speichernde Sicherheitsinformation mit dem zweiten logischen Zustand zugeführt. Sofern es dabei zu keiner Funktionsstörung kommt, wird diese Sicherheitsinformation korrekt mit dem zweiten logischen Zustand in die Sicherheitsspeicherzelle eingeschrieben. Kommt es dagegen zu einer Funktionsstörung, hat die eingeschriebene Sicherheitsinformation nicht den zweiten, sondern den ersten logischen Zustand. Wird dann zu einem späteren Zeitpunkt das erfindungsgemäße Betriebsverfahren erneut durchgeführt, wird diese Funktionsstörung, wie bereits oben beschrieben, detektiert und das Fehlersignal generiert.

Das beschriebene Verfahren kann bei jedem Speicherzellenzugriff durchgeführt werden. Um den Zeitaufwand für die Durchführung des erfindungsgemäßen Betriebsverfahrens jedoch möglichst gering zu halten, ist es zweckmäßig, dieses nur bei jeder Initialisierung des Speichers durchzuführen. Es wird dann beispielsweise nur beim ersten Auslesen einer der Speicherzellen durchgeführt. Somit kann festgestellt werden, ob beim vor der Initialisierung des Speichers erfolgten Betrieb des Speichers eine Funktionsstörung aufgetreten ist.

Günstig ist es, wenn die Sicherheitsspeicherzelle und die Speicherzellen des Speichers den gleichen Aufbau haben. Dann ist sichergestellt, daß sich Funktionsstörungen des Speichers sowohl bei einem Schreibzugriff auf die Sicherheitsspeicherzelle als auch bei einem Schreibzugriff auf eine der Speicherzellen gleich auswirken.

Vorteilhaft ist es weiterhin, nach dem Auslesen der Sicherheitsinformation aus der Sicherheitsspeicherzelle und vor dem Einschreiben der neuen Sicherheitsinformation ein Datum des ersten logischen Zustands in der Sicherheitsspeicherzelle zu erzeugen. Dies gewährleistet, daß auch bei einem Speicher, dessen Speicherinhalte beim Lesen nicht zerstört werden, nur dann ein Datum des zweiten logischen Zustands in der Sicherheitsspeicherzelle gespeichert ist, wenn das Einschreiben der neuen Sicherheitsinformation des zweiten logischen Zustands in korrekter Weise erfolgt.

Dabei ist es günstig, wenn die Sicherheitsspeicherzelle bereits so gestaltet ist, daß ihr Speicherinhalt bei einem Lesezugriff zerstört wird, so daß sie nach dem Lesezugriff, unabhängig vom zuvor gespeicherten Datum, ein Datum des ersten logischen Zustands enthält. Hierdurch wird automatisch erreicht, daß nach dem Lesezugriff ein Datum des ersten logischen Zustands in der Sicherheitsspeicherzelle gespeichert ist. Der Sicherheitsspeicherzelle muß also in diesem Fall ein solches Datum nicht extra zugeführt werden. Hierfür eignen sich alle Speicher, bei denen ein zerstörendes Lesen erfolgt, 5 wie z.B. DRAMs und FRAMs.

Die Erfindung wird im folgenden anhand der Figuren näher erläutert, die Ausführungsbeispiele darstellen.

Es zeigen:
- Figur 1: ein Ablaufdiagramm des erfindungsgemäßen Betriebsverfahrens,
- Figur 2: ein Ausführungsbeispiel des erfindungsgemäßen integrierten Speichers und
- Figur 3: den Aufbau einer Speicherzelle und einer Sicherheitsspeicherzelle des integrierten Speichers aus Figur 2.

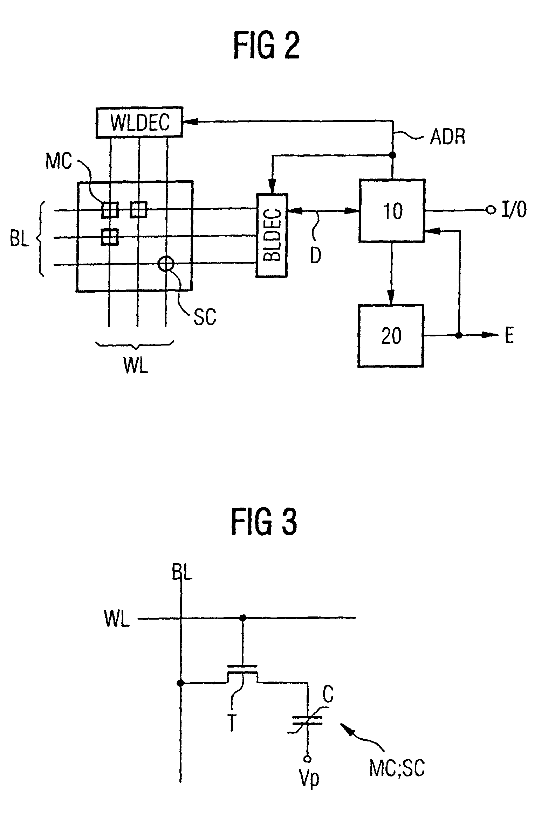

Figur 2 zeigt einen ferroelektrischen Speicher vom Typ FRAM mit beschreibbaren Speicherzellen MC und einer beschreibbaren Sicherheitsspeicherzelle SC, die jeweils in Kreuzungspunkten von Bitleitungen BL und Wortleitungen WL angeordnet sind.

Die Speicherzellen MC und die Sicherheitsspeicherzelle SC haben den in Figur 3 gezeigten Aufbau. Sie weisen einen Auswahltransistor T und einen Speicherkondensator C mit ferroelektrischem Dielektrikum auf. Die eine Elektrode des Speicherkondensators C ist mit einem Plattenpotential V_{P} einer Zellplatte des Speichers verbunden. Die andere Elektrode des Speicherkondensators C ist über einen Auswahltransistor T mit einer der Bitleitungen BL verbunden. Das Gate des Auswahltransistors T ist mit einer der Wortleitungen WL Verbunden. Bei diesem Ausführungsbeispiel hat das Plattenpotential V_{P}. einen Wert, der dem arithmetischen Mittel zweier Versorgungspotentiale des Speichers entspricht.

Zum Einschreiben einer logischen Null wird die Bitleitung BL auf das niedrige Versorgungspotential (z.B. 0 Volt) gebracht. Anschließend wird der Auswahltransistor T über die Wortleitung WL leitend geschaltet, so daß die Polarisation des ferroelektrischen Dielektrikums innerhalb des Speicherkondensators C und damit seine Kapazität einen ersten Wert annimmt. Zum Einschreiben einer logischen Eins wird das Potential der Bitleitung BL auf das höhere Versorgungspotential gebracht, wodurch die Polarisation des Dielektrikums und dessen Kapazität einen zweiten Wert annimmt. Solange kein Zugriff auf die Speicherzelle MC erfolgt, ist der Auswahltransistor T gesperrt und die Bitleitung BL ist auf dem Plattenpotential Vₚ. In diesem Zustand liegt am Speicherkondensator C keine Spannung an, so daß er seine Polarisation unverändert beibehält.

Zum Auslesen eines in der Speicherzelle MC gespeicherten Datums wird die Bitleitung BL auf das niedrige Versorgungspotential (Null Volt) gebracht. Nach dem Leitendschalten des Auswahltransistors T wird beobachtet, um welchen Betrag sich das Potential der vorgeladenen Bitleitung BL verändert. Die unterschiedlichen Polarisationszustände des Speicherkondensators, die den unterschiedlichen logischen Zuständen entsprechen, haben nämlich jeweils einen anderen Wert der Kapazität des Speicherkondensators C zur Folge. Ist seine Kapazität groß, ändert sich das Potential der Bitleitung BL stärker, als wenn seine Kapazität kleiner ist. Da die Bitleitung BL beim Auslesen auf den Wert des niedrigen Versorgungspotentials vorgeladen wurde, ist anschließend in der Speicherzelle MC, unabhängig vom zuvor in ihr gespeicherten Datum, immer eine logische Null gespeichert. Es handelt sich bei diesem Speicher also um den Speicherzelleninhalt zerstörende Lesezugriffe ("destructive read").

Gemäß Figur 2 werden die Wortleitungen WL über einen Wortleitungsdecoder WLDEC und die Bitleitungen BL über einen Bitleitungsdecoder BLDEC angesteuert. Die Decoder wählen jeweils eine der Wortleitungen WL und eine der Bitleitungen BL aus, in Abhängigkeit von ihnen zugeführten Adressen ADR.

Der Speicher weist weiterhin eine Steuereinheit 10 und eine Prüfeinheit 20 auf. Die Steuereinheit 10 dient zum Auslesen einer in der Sicherheitsspeicherzelle SC gespeicherten Sicherheitsinformation bei einem auf eine der Speicherzellen MC erfolgenden Schreib- und/oder Lesezugriff. Sie ist mit dem Bitleitungsdecoder BLDEC über eine Datenleitung D verbunden, über die Daten von und zu einer der Speicherzellen MC oder eine Sicherheitsinformation von oder zu der Sicherheitsspeicherzelle SC übertragen werden können. Zur Adressierung der entsprechenden Speicherzelle MC oder der Sicherheitsspeicherzelle SC übermittelt die Steuereinheit 10 die Adressen ADR an die beiden Decoder WLDEC oder BLDEC. Die Steuereinheit 10 ist mit einem Ein-/Ausgang I/O verbunden, von dem sie in eine der Speicherzellen MC einzuschreibende Daten empfängt beziehungsweise an den sie aus einer der Speicherzellen MC ausgelesene Daten ausgibt.

Die Prüfeinheit 20 ist mit der Steuereinheit 10 verbunden und dient zum Prüfen der aus der Sicherheitsspeicherzelle SC ausgelesene Sicherheitsinformation und zur Erzeugung eines Fehlersignals E, wenn die ausgelesene Sicherheitsinformation eine logische Null ist. Die Prüfeinheit 20 gibt das Fehlersignal E nach außerhalb des Speichers aus. Außerdem übermittelt sie das Fehlersignal E zurück an die Steuereinheit 10, die durch das Fehlersignal E deaktiviert wird. Anschließend ist keine Datenübertragung über den Ein-/Ausgang I/O von oder zum Speicher möglich. Wenn die ausgelesene Sicherheitsinformation, die in der Sicherheitsspeicherzelle SC gespeichert ist, eine logische Eins ist, wird das Fehlersignal E nicht generiert und die Steuereinheit 10 führt weiterhin die Zugriffe auf die Speicherzellen MC aus.

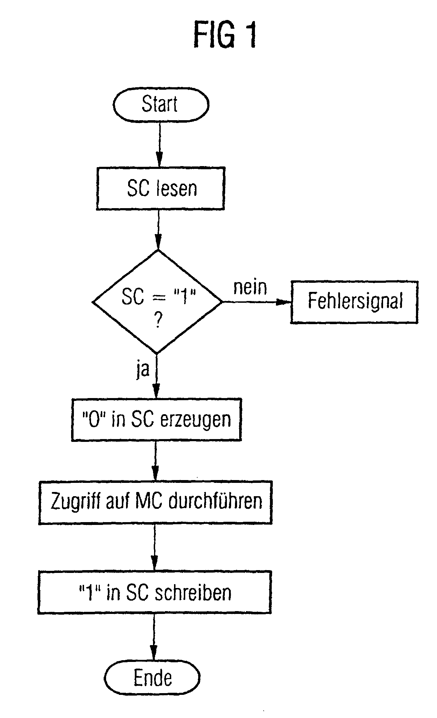

Anhand von Figur 1 wird im folgenden das erfindungsgemäße Betriebsverfahren erläutert. Bei einem auf eine der Speicherzellen MC durchzuführenden Schreib- und/oder Lesezugriff erfolgt zunächst ein Lesezugriff auf die Sicherheitsspeicherzelle SC. Durch die Prüfeinheit 20 wird dabei überprüft, ob die ausgelesene Sicherheitsinformation eine logische Eins ist. Ist dies nicht der Fall, wird das Fehlersignal E generiert und die Steuereinheit 10 deaktiviert. Im gegenteiligen Fall wird in der Sicherheitsspeicherzelle SC eine logische Null erzeugt. Dies erfolgt bei dem hier diskutierten Ausführungsbeispiel, wie bereits anhand Figur 3 erläutert, automatisch bei jedem auf die Sicherheitsspeicherzelle SC erfolgenden Lesezugriff. Das bedeutet, das die logische Null bereits durch das Auslesen der Sicherheitsinformation aus der Sicherheitsspeicherzelle SC in dieser erzeugt wurde. Als nächster Schritt wird der gewünschte Zugriff auf die Speicherzelle MC durchgeführt. Anschließend wird eine logische Eins in die Sicherheitsspeicherzelle SC eingeschrieben.

Da als letzter Schritt des Betriebsverfahrens der Sicherheitsspeicherzelle SC als neue zu speichernde Sicherheitsinformation eine logische Eins zugeführt wird, zeigt die Generierung des Fehlersignals E bei der nächstfolgenden Durchführung des Verfahrens an, daß diese logische Eins aufgrund einer Funktionsstörung des Speichers nicht korrekt in der Sicherheitsspeicherzelle SC gespeichert wurde. Durch das Fehlersignal E wird der Betreiber des Speichers auf diese Fehlfunktion aufmerksam gemacht, da nicht auszuschließen ist, daß diese sich auch auf das Speichern von Daten in den normalen Speicherzellen MC ausgewirkt hat.

Das anhand Figur 1 erläuterte Verfahren kann bei jedem Zugriff auf eine der Speicherzellen MC durchgeführt werden oder lediglich nach einer Initialisierung des Speichers.

Bei anderen Ausführungsbeispielen der Erfindung ist es auch möglich, daß durch das von der Prüfeinheit 20 generierte Fehlersignal E lediglich eine Deaktivierung der Steuereinheit 10 erfolgt und das Fehlersignal E nicht nach außerhalb des Speichers übermittelt wird. Ebenso gut sind Ausführungsbeispiele möglich, bei denen das Fehlersignal E lediglich nach außerhalb des Speichers übermittelt wird, nicht jedoch zur Deaktivierung der Steuereinheit 10 dient.

Da, wie anhand Figur 3 erläutert, beim Auslesen der Speicherzellen MC deren Speicherinhalt grundsätzlich zerstört wird, indem dabei eine logische Null in der Speicherzelle MC erzeugt wird, ist es erforderlich, nach dem Auslesen die ausgelesene Information - gegebenenfalls verstärkt - wieder in die Speicherzelle zurückzuschreiben. Dieses Rückschreiben ist nicht nur von FRAMs, sondern auch von DRAMs bekannt. Das Rückschreiben, das während eines Lesezugriffs durchgeführt wird, unterscheidet sich dabei nicht von einem Schreibzugriff auf die Speicherzelle. Da es auch hierbei wieder zu Funktionsstörungen kommen kann, ist die Durchführung des erfindungsgemäßen Betriebsverfahrens nicht nur bei reinen Schreibzugriffen auf die Speicherzellen MC, sondern auch bei Lesezugriffen sinnvoll.

Die durch die Prüfeinheit 20 detektierten Funktionsstörungen des Speichers können beispielsweise aufgrund von ungewollten äußeren Manipulationen des Speichers ausgelöst worden sein. Daher ist die Anwendung der Erfindung insbesondere bei sicherheitsrelevanten Speichern, wie sie beispielsweise in Chipkarten zum Einsatz kommen, sinnvoll.

Während beim hier vorgestellten Ausführungsbeispiel nur eine Sicherheitsspeicherzelle SC für den gesamten Speicher vörgesehen ist, sind andere Ausführungsbeispiele möglich, bei denen die Speicherzellen MC in Gruppen eingeteilt sind, denen jeweils eine Sicherheitsspeicherzelle SC der beschriebenen Art zugeordnet ist. Beispielsweise kann eine Sicherheitsspeicherzelle SC pro Speicherblock vorgesehen sein.

Bei Ausfall der Spannungsversorgung des Speichers findet kein ordnungsgemäßes Beschreiben der Sicherheitsspeicherzelle am Ende eines Schreib- und/oder Lesezugriffs statt. Auch dann wird das Fehlersignal auf die erfindungsgemäße Weise generiert, wenn zuvor eine logische Null in der Sicherheitsspeicherzelle erzeugt wurde. Die logische Null kann entweder durch einen zerstörenden Lesezugriff oder durch direktes Einschreiben in der Sicherheitsspeicherzelle erzeugt werden.

## Patentansprüche

1. Betriebsverfahren für einen integrierten Speicher, der in Kreuzungspunkten von Wortleitungen (WL) und Bitleitungen (BL) angeordnete beschreibbare Speicherzellen (MC) zum Speichern von Daten und eine beschreibbare Sicherheitsspeicherzelle (SC) zum Speichern einer Sicherheitsinformation aufweist, mit folgenden bei einem Schreib- und/oder Lesezugriff vorzunehmenden Schritten:
- vor dem Schreib- und/oder Lesezugriff auf eine der Speicherzellen (MC) wird die in der Sicherheitsspeicherzelle (SC) gespeicherte Sicherheitsinformation ausgelesen,
- wenn die ausgelesene Sicherheitsinformation einen ersten logischen Zustand (0) aufweist, wird ein Fehlersignal (E) generiert,
und wenn die ausgelesene Sicherheitsinformation einen zweiten logischen Zustand (1) aufweist, wird der Zugriff auf die Speicherzelle (MC) durchgeführt und auf die Sicherheitsspeicherzelle (SC) erfolgt ein Schreibzugriff, bei dem dieser eine neue zu speichernde Sicherheitsinformation, die den zweiten logischen Zustand (1) hat, zugeführt wird.

2. Betriebsverfahren nach Anspruch 1,
das bei jeder Initialisierung des Speichers durchgeführt wird.

3. Betriebsverfahren nach Anspruch 1 oder 2,
bei dem nach dem Auslesen der Sicherheitsinformation aus der Sicherheitsspeicherzelle (SC) und vor dem Einschreiben der neuen Sicherheitsinformation ein Datum des ersten logischen Zustandes (O) in der Sicherheitsspeicherzelle (SC) erzeugt wird.

4. Integrierter Speicher
- mit beschreibbaren Speicherzellen (MC) zum Speichern von Daten und mit einer beschreibbaren Sicherheitsspeicherzelle (SC) zum Speichern einer Sicherheitsinformation,
- mit einer Steuereinheit (10) zum Auslesen der in der Sicherheitsspeicherzelle (SC) gespeicherten Sicherheitsinformation bei einem auf eine der Speicherzellen (MC) erfolgenden Schreib- und/oder Lesezugriff,
- und mit einer Prüfeinheit (20) zum Prüfen der aus der Sicherheitsspeicherzelle (SC) ausgelesenen Sicherheitsinformation und zur Erzeugung eines Fehlersignals (E), wenn die ausgelesene Sicherheitsinformation einen ersten logischen Zustand (0) hat,
- dessen Steuereinheit (10) zur Durchführung eines auf das Auslesen der Sicherheitsinformation folgenden Zugriffs auf die Speicherzelle (MC) sowie eines Schreibzugriffs auf die Sicherheitsspeicherzelle (SC) dient, bei dem sie der Sicherheitsspeicherzelle eine neue zu speichernde Sicherheitsinformation eines zweiten logischen Zustands (1) zuführt, wenn von der Prüfeinheit (20) zuvor kein Fehlersignal (E) erzeugt wurde.

5. Integrierter Speicher nach Anspruch 4,
dessen Sicherheitsspeicherzelle (SC) so gestaltet ist, daß ihr Speicherinhalt bei einem Lesezugriff zerstört wird, so daß sie nach dem Lesezugriff, unabhängig vom zuvor gespeicherten Datum, ein Datum des ersten logischen Zustands (0) enthält.

6. Integrierter Speicher nach Anspruch 5,
dessen Sicherheitsspeicherzelle (SC) eine ferroelektrische Speicherzelle ist.

7. Integrierter Speicher nach Anspruch 4,
dessen Sicherheitsspeicherzelle (SC) so wie dessen Speicherzellen (MC) aufgebaut ist.

## Claims

1. Operating method for an integrated memory which has writeable memory cells (MC) arranged at crossover points between word lines (WL) and bit lines (BL), for storing data, and a writeable security memory cell (SC) for storing a security information item, having the following steps to be performed in the event of a write and/or read access:
- before the write and/or read access to one of the memory cells (MC), the security information item stored in the security memory cell (SC) is read out,
- if the security information item read out has a first logic state (0), an error signal (E) is generated,
and if the security information item read out has a second logic state (1), the access to the memory cell (MC) is carried out and a write access is made to the security memory cell (SC), during which write access a new security information item to be stored, which has the second logic state (1) is fed to said security memory cell.

2. Operating method according to Claim 1,
which is carried out each time the memory is initialized.

3. Operating method according to Claim 1 or 2,
in which, after the security information item has been read from the security memory cell (SC) and before the new security information item has been written in, a datum of the first logic state (0) is generated in the security memory cell (SC).

4. Integrated memory
- having writeable memory cells (MC) for storing data and having a writeable security memory cell (SC) for storing a security information item,
- having a control unit (10) for reading out the security information item stored in the security memory cell (SC) in the event of a write and/or read access to be made to one of the memory cells (MC),
- and having a checking unit (20) for checking the security information item read from the security memory cell (SC) and for generating an error signal (E) if the security information item read out has a first logic state (0),
- whose control unit (10) serves for carrying out an access to the memory cell (MC), which follows the read-out of the security information item, and a write access to the security memory cell (SC), and during which said control unit feeds to the security memory cell a new security information item to be stored, having a second logic state (1), if no error signal (E) was previously generated by the checking unit (20).

5. Integrated memory according to Claim 4,
whose security memory cell (SC) is configured in such a way that its memory content is destroyed in the event of a read access, with the result that it contains a datum of the first logic state (0) after the read access, irrespective of the previously stored datum.

6. Integrated memory according to Claim 5,
whose security memory cell (SC) is a ferroelectric memory cell.

7. Integrated memory according to Claim 4,
whose security memory cell (SC) is constructed in the same way as its memory cells (MC).

## Revendications

1. Procédé pour faire fonctionner une mémoire intégrée qui a, aux points d'intersection de lignes (WL) de mots et de lignes (BL) de bits, des cellules (MC) de mémoire dans lesquelles on peut écrire et qui sont destinées à mémoriser des données et une cellule (SC) de mémoire de sécurité dans laquelle on peut écrire et qui est destinée à mémoriser une information de sécurité, comprenant les stades suivants s'effectuant lors d'un accès en écriture et/ou d'un accès en lecture :
- avant l'accès en écriture et/ou en lecture à l'une des cellules (MC) de mémoire, on lit l'information de sécurité mémorisée dans la cellule (SC) de mémoire de sécurité,
- si l'information de sécurité qui est lue a un premier état (0) logique, il est engendré un signal (E) de défaut,
et si l'information de sécurité qui est lue a un deuxième état (1) logique, on effectue l'accès à la cellule (MC) de mémoire et on effectue un accès en écriture à la cellule (SC) de mémoire de sécurité, dans lequel on envoie à celle-ci une information de sécurité à mémoriser qui est nouvelle et qui a le deuxième état (1) logique.

2. Procédé suivant la revendication 1, qui est effectué à chaque initialisation de la mémoire.

3. Procédé suivant la revendication 1 ou 2, dans lequel on produit, après la lecture de l'information de sécurité dans la cellule (SC) de mémoire de sécurité et avant l'écriture de la nouvelle information de sécurité, une donnée ayant le premier état (0) logique dans la cellule (SC) de mémoire de sécurité.

4. Mémoire intégrée
- comprenant des cellules (MC) de mémoire dans lesquelles on peut écrire et qui sont destinées à mémoriser des données et une cellule (SC) de mémoire de sécurité dans laquelle on peut écrire et qui est destinée à mémoriser une information de sécurité,
- comprenant une unité (10) de commande pour lire l'information de sécurité mémorisée dans la cellule (SC) de mémoire de sécurité lors d'un accès en écriture et/ou en lecture s'effectuant sur l'une des cellules (MC) de la mémoire,
- et comprenant une unité (20) de contrôle destinée à contrôler l'information de sécurité qui est lue dans la cellule (SC) de mémoire de sécurité et à produire un signal (E) d'erreur si l'information de sécurité qui est lue a un premier état (0) logique,
- dont l'unité (10) de commande sert à effectuer un accès à la cellule (MC) de mémoire suivant la lecture de l'information de sécurité, ainsi qu'un accès en écriture à la cellule (SC) de mémoire de sécurité dans lequel elle envoie à la cellule de mémoire de sécurité une information de sécurité nouvelle à mémoriser d'un deuxième état (1) logique si un signal (E) d'erreur n'a pas été produit auparavant par l'unité (20) de contrôle.

5. Mémoire intégrée suivant la revendication 4, dont la cellule (SC) de mémoire de sécurité est conformée de manière que son contenu de mémoire soit détruit lors d'un accès en lecture, de sorte qu'elle contient après l'accès en lecture, indépendamment de la donnée mémorisée auparavant, une donnée ayant le premier état (0) logique.

6. Mémoire intégrée suivant la revendication 5, dont la cellule (SC) de mémoire de sécurité est une cellule de mémoire ferroélectrique.

7. Mémoire intégrée suivant la revendication 4, dont la cellule (SC) de mémoire de sécurité est constituée comme ses cellules (MC) de mémoire.
